(19) Europäisches Patentamt
European Patent Office
Office européen des brevets

(11) **EP 1 955 844 B1**

(12) **EUROPEAN PATENT SPECIFICATION**

(45) Date of publication and mention
of the grant of the patent:
**05.06.2013 Bulletin 2013/23**

(21) Application number: **06833193.3**

(22) Date of filing: **24.11.2006**

(51) Int Cl.:
*B32B 27/32* (2006.01)  *H01L 23/29* (2006.01)
*H01L 23/31* (2006.01)  *H01L 31/04* (2006.01)

(86) International application number:
**PCT/JP2006/323389**

(87) International publication number:
**WO 2007/061026 (31.05.2007 Gazette 2007/22)**

(54) **COMPOSITE SHEET AND USE THEREOF**

VERBUNDFOLIE UND VERWENDUNG DAVON

FEUILLE COMPOSITE ET SON UTILISATION

(84) Designated Contracting States:
**DE FR GB**

(30) Priority: **25.11.2005 JP 2005340363**

(43) Date of publication of application:
**13.08.2008 Bulletin 2008/33**

(73) Proprietor: **Mitsui Chemicals, Inc.**
**Tokyo 105-7117 (JP)**

(72) Inventors:
• **HOYA, Hiroshi**
**Ichihara-shi**
**Chiba 299-0108 (JP)**

• **KAWAMOTO, Manabu**
**Chiyoda-ku**
**Tokyo102-0073 (JP)**

(74) Representative: **HOFFMANN EITLE**
**Patent- und Rechtsanwälte**
**Arabellastrasse 4**
**81925 München (DE)**

(56) References cited:
**WO-A1-2004/023565    JP-A- 05 278 183**
**JP-A- 09 094 929     JP-A- 2003 103 732**
**JP-A- 2003 152 212    JP-A- 2004 223 925**
**JP-A- 2005 125 530**

**Description**

BACKGROUND OF THE INVENTION

1. Field of the Invention

The present invention relates to a composite sheet suitably used in combination with various electric or electronic devices including a solar cell. More specifically, the invention relates to a composite sheet comprising a combination of a sealing sheet and a base sheet, and the invention further relates to uses of the composite sheet for a solar cell module, a power generating facility and the like.

2. Description of the Related Art

In recent years, the electric or electronic devices have been drastically developed, and have been widely used in various applications in every situation of the social or industrial field, or in the daily life. Generally, since the electric and electronic devices are easily affected by moisture, oxidizing materials or the like, it is usually practiced to seal the devices in order to achieve their stable operations and long service lives.

These days, various materials are prepared and supplied for sealing the electric and electronic devices, but among others, a sealing sheet made from an organic polymer is very useful since it covers relatively wide areas, and is simple to use and so on. Further, it is particularly preferably used to seal an electric and electronic device using light, particularly a solar cell, since it relatively easily assures transparency.

The solar cell is commonly used in the form of a solar cell module having the solar cell sealed since it is used outdoors, such as in the building roofings, in many cases. The solar cell module is configured such that the solar cell devices usually comprising polycrystalline silicone, etc. are laminated with solar cell seals comprising a soft transparent resin, wherein the solar cell devices are interposed between the seals, and both surfaces of the modules are covered with protective sheets for a solar cell module. That is, the solar cell module is typically configured to have a laminated structure of a surface protective sheet/a sealing sheet/a solar cell device/a sealing sheet/a base sheet (back protective sheet). Such solar cell module has weather resistance, and thus it is suitable to be used outdoors, such as in the building roofings.

The composite sheet having a combination of a protective sheet and a sealing sheet, or a sealing sheet and a base sheet, which is used in the above-described structure, it is preferably used for the protection of not only a solar cell but also a variety of electric or electronic devices, since the composite sheet can appropriately protect a device owing to the fact that each of the different layers of the sheet separately performs its own function of either protection (and shape maintenance) or sealing.

Conventionally, as the materials used for the composite sheet, an ethylene-vinyl acetate copolymer (EVA), which is excellent in transparency, flexibility or the like, for a sealing sheet, and polyethylene terephthalate (PET), which is excellent in strength, transparency or the like for a base sheet were generally used (see Patent Document 1, for example).

From the viewpoint for achieving sufficient service life of the electric or electronic device, etc., it is needed that the base sheet be excellent in barrier property that blocks off moisture and the like. However, the polyethylene terephthalate resin, in terms of achieving the purpose, does not necessarily has sufficient moisture barrier property, and thus it has been needed to improve the barrier property.

The polypropylene resin, in particular, a biaxially stretched polypropylene resin film, is excellent in the moisture barrier property, and available at a relatively low cost, and thus it is expected to improve the moisture barrier property by using it (see, for example, Patent Document 2). However, EVA was not necessarily sufficient in the adhesiveness with a polypropylene resin, and thus it has not been easy to utilize the sealing sheet using EVA in combination with the polypropylene resin.

Further, if EVA is used for a solar cell sealing sheet, it is general to carry out crosslinking treatment so as to provide sufficient heat resistance. However, since it takes a period of time as long as 1 to 2 hours for the crosslinking treatment to be performed, the treatment has been a cause of reduction in the production rate and the production efficiency of solar cell modules. Moreover, there has been a concern about a risk that components such as an acetic acid gas, generated upon decomposition of the EVA, may affect the solar cell device.

[Patent Document 1] Japanese Laid-Open Patent Application No. 2002-134768
[Patent Document 2] Japanese Laid-Open Patent Application No. 2003-092421

## SUMMARY OF THE INVENTION

### PROBLEMS TO BE SOLVED

It is an object of the present invention to provide a composite sheet with excellent characteristics, comprising a sealing sheet, which can be used instead of the sealing sheet comprising the conventionally used EVA and has good adhesiveness with a polypropylene resin and good productivity, in combination with an appropriate base sheet.

### MEANS TO SOLVE THE PROBLEMS

The present inventors have studied intensively to solve the above problems, and, as a result, have found that a sealing sheet comprising a thermoplastic composition, which is a combination of specific propylene polymers, having a permanent compression set in a specific range is excellent in the adhesiveness with a sheet comprising a polypropylene resin, and is provided with preferable characteristics for a sealing sheet, and have completed the present invention by combining the base sheet made from the polypropylene resin with the sealing sheet.

According to the present invention, there is provided a composite sheet comprising:

a sealing sheet (I) one of whose layers comprises a thermoplastic resin composition comprising:

(i) 0 to 90 parts by weight of a propylene polymer (A) having a melting point, as measured by a differential scanning calorimeter, of 100°C or higher, and
(ii) 10 to 100 parts by weight of a propylene copolymer (B) formed from propylene and at least one olefin selected from the group consisting of ethylene and α-olefins having 4 to 10 carbon atoms, the copolymer having a shore A hardness of 30 to 80, a melting point, as measured by a differential scanning calorimeter, of lower than 100°C or has no melting point to be observed (with the total of (A) and (B) being 100 parts by weight),

wherein the thermoplastic resin composition has a permanent compression set measured at 23°C of 5 to 35%, and a permanent compression set measured at 70°C of 50 to 70%, the permanent compression set of the thermoplastic resin being measured by stacking six press sheets of the resin each having a thickness of 2 mm, compressing the stack by 25%, maintaining the compressed stack at the measurement temperature (23°C or 70°C) for 24 hours and releasing the stack from compression, the permanent compression set being determined by the equation:

$$\text{Permanent compression set} = \frac{\{(\text{Thickness before test}) - (\text{Thickness after test})\}}{\{(\text{Thickness before test}) - (\text{Thickness upon compression})\}}; \text{ and}$$

a base sheet (II) one of whose layers comprises a polypropylene resin.

As used herein, the expression "comprising - (A) 0 to 90 parts by weight and - (B) 10 to 100 pars by weight" encompasses both of the case where the whole thermoplastic resin composition consists of (A) and (B), and the case where a part of the thermoplastic resin composition consists of (A) and (B). As used herein, the expression "- comprising a thermoplastic resin composition" encompasses both of the case where the whole sealing sheet consists of the thermoplastic resin composition, and the case where a part of the sealing sheet consists of the thermoplastic resin composition. In addition, as used herein, the expression "- comprising a polypropylene resin" encompasses both of the case where the whole base sheet consists of the polypropylene resin, and the case where a part of the base sheet consists of the polypropylene resin.

Hereinbelow, the following items (2) through (8) are preferable embodiments of the invention, respectively.

(2) The composite sheet as described in (1), wherein the propylene copolymer (B) comprises 45 to 92 mol% of constitutional units derived from propylene, 5 to 25 mol% of constitutional units derived from ethylene and 3 to 30 mol% of constitutional units (a) derived from (an) α-olefin(s) having 4 to 20 carbon atoms.
(3) The composite sheet as described in (1) or (2), wherein the base sheet (II) is biaxially stretched.
(4) The composite sheet as described in any one of (1) to (3), wherein the base sheet (II) has a metal or inorganic compound layer on its surface.
(5) The composite sheet as described in any one of (1) to (4), wherein the sealing sheet (I) and the base sheet (II) are directly laminated.
(6) The composite sheet as described in any one of (1) to (5), which is used for sealing a solar cell.
(7) A solar cell module prepared by using the composite sheet as described in any one of (1) to (6).
(8) A power generating facility having the solar cell module as described in (7).

Effects of the Invention

According to the invention, a composite sheet having good adhesiveness between the base sheet and the sealing sheet, and good productivity, can be obtained. Further, for this composite sheet, even when the heating and the adhesion are carried out at a low temperature to adhere the sealing sheet to the base sheet, the transparency of the sheet is not deteriorated. This composite sheet is suitably used for the preparation of an electric or electronic device including a solar cell device, thus it is highly valuable in practical use.

BRIEF DESCRIPTION OF THE DRAWINGS

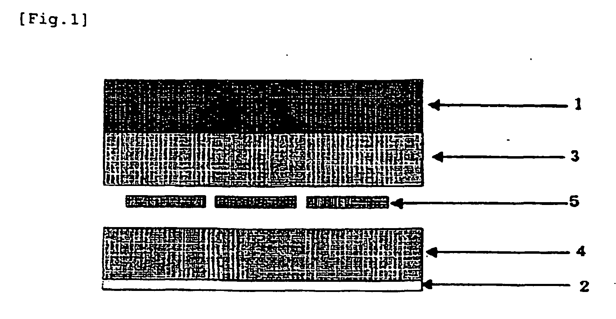

Fig. 1 is a cross-sectional diagram showing briefly an example of the solar cell module according to a preferable embodiment of the present invention. Sealing is performed between 3 and 4.

[Reference Numerals]

1: Glass (surface protective sheet)
2: Biaxial stretched polypropylene (base sheet (back protective sheet))
3 and 4: Sealing sheets
5: Solar cell device

DESCRIPTION OF THE PREFERRED EMBODIMENTS

The present invention relates to a composite sheet comprising

- at least one layer of a sealing sheet (I) made from a thermoplastic resin composition comprising
0 to 90 parts by weight of a propylene polymer (A) having a melting point, as measured by a differential scanning calorimeter, of 100°C or higher, and
10 to 100 parts by weight of a propylene copolymer (B), wherein the copolymer is formed from propylene, and at least one olefin selected from the group consisting of ethylene and $\alpha$-olefins having 4 to 10 carbon atoms and the copolymer has a shore A hardness of 30 to 80 and has a melting point, as measured by a differential scanning calorimeter, of lower than 100°C, or has no melting point to be observed (with the total of (A) and (B) being 100 parts by weight), wherein the thermoplastic resin composition has a permanent compression set, as measured at 23°C, of 5 to 35%, and a permanent compression set, as measured at 70°C, of 50 to 70%; and
- at least one layer of a base sheet (II) comprising a polypropylene resin.

Hereinbelow, preferable embodiments of the present invention will be described.

Composite sheet

It is sufficient that the composite sheet of the invention comprises at least one layer of the sealing sheet (I) and at least one layer of the base sheet (II).

Sealing sheet (I)

Thermoplastic resin composition

The sealing sheet (I) constituting a part of the composite sheet of the invention comprises a thermoplastic resin composition comprising a propylene polymer (A) and a propylene copolymer (B) in the blending amounts described below.
Specifically, the thermoplastic resin composition used in the sealing sheet (I) constituting a part of the composite sheet of the invention is a thermoplastic resin composition comprising 0 to 90 parts by weight, preferably 0 to 70 parts by weight, more preferably 10 to 50 parts by weight of the propylene polymer (A), and 10 to 100 parts by weight, preferably 30 to 100 parts by weight, more preferably 50 to 90 parts by weight of the propylene copolymer (B), wherein the total amount of (A) and (B) is 100 parts by weight. The thermoplastic resin composition used in the sealing sheet (I) may contain a component other than the (A) and (B) described above, for example, a resin other than (A) and (B), a rubber, an inorganic filler or the like within the range not adversely affecting the purpose of the invention.

If the blending amounts of the components (A) and (B) are within the above range, the obtained sealing sheet (I) has good heat resistance, good transparency, good flexibility or the like, as well as the sealing sheet (I) has good moldability, thus it is preferable.

The thermoplastic resin composition used in the sealing sheet (I) has a permanent compression set, as measured at 23°C, of 5 to 35%, and a permanent compression set, as measured at 70°C, of 50 to 70%. If the permanent compression set is within the above range, the deformation of the sheet under a wide condition from normal temperature to high temperature can be prevented, and thus, when particularly a solar cell is sealed, reduction of the power generation yield of the solar cell can be avoided. In particular, the condition that the permanent compression set, as measured at 70°C, is within the above range is especially important, since deformation of the sheet under a load in a long period of time by the weight of members of the solar cell module such as glass can be inhibited. The permanent compression set, as measured at 23°C, is more preferably 5 to 30%, even more preferably 5 to 25%. The permanent compression set, as measured at 70°C, is more preferably, 50 to 68%, even more preferably 50 to 66%. The permanent compression set can be measured in accordance with JIS K 6301 in the following manner. That is, 6 press sheets each having a thickness of 2 mm were stacked and compressed by 25%, maintained at a predetermined temperature (23°C or 70°C) for 24 hours, and then released. Thereafter, the thickness after the test was measured. From this result, a residual set after maintenance for 24 hours (permanent compression set) was determined according to the following equation.

$$\text{Residual set} = (\text{Thickness before test} - \text{Thickness after test}) / (\text{Thickness before test} - \text{Thickness upon compression})$$

The thermoplastic resin composition used in the sealing sheet (I) has a Shore A hardness of usually 55 to 92, preferably 60 to 80. If the Shore A hardness is within this range, generation of cracks in the device upon the encapsulation of a solar cell, etc. can be prevented. Also, an encapsulated solar cell, etc. having flexibility is obtained, and the solar cell, etc. can be protected against deformation or impact, thus it is preferable.

Propylene polymer (A)

Examples of the propylene copolymer (A) used in the invention include a propylene homopolymer, and a copolymer of propylene and at least one $\alpha$-olefin having 2 to 20 carbon atoms other than propylene. Herein, specific examples of the $\alpha$-olefin having 2 to 20 carbon atoms other than propylene include ethylene, 1-butene, 1-pentene, 1-hexene, 4-methyl-1-pentene, 1-octene, 1-decene, 1-dodecene, 1-tetradecene, 1-hexadecene, 1-octadecene and 1-eicosene, of which ethylene or an $\alpha$-olefin having 4 to 10 carbon atoms is preferable.

These $\alpha$-olefins may form a random or block copolymer with propylene.

Constitutional units derived from these $\alpha$-olefins may be contained in the polypropylene in a proportion of 35 mol% or less, and preferably 30 mol% or less.

The propylene polymer (A) preferably has a melt flow rate (MFR), as determined in accordance with ASTM D1238 at 230°C and a load of 2.16 kg, in the range of 0.01 to 1000 g/10 min, preferably 0.05 to 100 g/10 min.

The propylene polymer (A) has a melting point, as measured with a differential scanning calorimeter, in the range of 100°C or higher, preferably 100 to 160°C, and more preferably 110 to 150°C.

The propylene polymer (A) of the invention may have any one of isotactic and syndiotactic structures, but the polymer having an isotactic structure is preferable in terms of heat resistance or the like.

The propylene polymer (A) used in the invention has an isotactic pentad fraction, as measured by an NMR method, of 0.94 or more, and preferably of 0.95 or more.

The isotactic pentad fraction (mmmm) means a proportion of the isotactic chains present in the pentad units in the molecular chains, as measured using $^{13}$C-NMR spectrum. That is, the isotactic pentad fraction is a fraction of propylene monomer units existing in the center of a chain in which five propylene monomer units are linked in succession in the meso bond. Specifically, the isotactic pentad fraction is measured as an intensity fraction of mmmm peak in all absorption peaks in the methyl carbon region of $^{13}$C-NMR spectrum. The isotactic pentad fraction (mmmm) is usually measured as follow.

The mmmm fraction is determined by Pmmmm (absorption intensity derived from the third methyl groups in the sequences where five propylene units are linked in succession in isotactic bond) and Pw (absorption intensity derived from all the methyl groups in propylene units) in the $^{13}$C-NMR spectrum, using the following equation.

$$\texttt{mmmm Fraction = Pmmmm/PW}$$

NMR measurement is carried out, for example, in the following manner. That is, 0.35 g of the sample is heated and dissolved in 2.0 ml of hexachlorobutadiene, and the resulting solution is filtered through a glass filter (G2). To the filtrate, added is 0.5 ml of deuterated benzene, and the resulting mixture is introduced into a NMR tube having an inner diameter of 10 mm, followed by measurement of the $^{13}$C-NMR spectrum at 120°C by the use of an NMR measuring apparatus, GX-500 type, manufactured by Japan Electron Optics Laboratory Co., Ltd. The number of integration times is 10,000 or more.

Furthermore, two or more propylene polymers (A) can be used together if necessary. For example, two or more components having a different melting point or rigidity can also be used.

As the propylene polymers (A), a homopolypropylene having excellent heat resistance (a known one having usually 3 mol% or less of copolymerizing components other than propylene), a block polypropylene having an excellent balance between heat resistance and flexibility (a known one having usually 3 to 30% by weight of n-decane soluble rubber components), and/or a random polypropylene having an excellent balance between flexibility and transparency (a known one having usually a melting peak, as measured by a differential scanning calorimeter (DSC), of 100°C or more, preferably in the range of 110 to 150°C), can be used as alone or in combination in order to obtain desired properties.

Such the propylene polymers (A) can be prepared, for example, by polymerization of propylene or copolymerization of propylene and other $\alpha$-olefin(s) in the presence of a Ziegler catalyst system comprising a solid catalyst component containing magnesium, titanium, halogen and an electron donor as essential components, an organoaluminum compound and an electron donor, or a metallocene catalyst system using a metallocene compound as one component of the catalyst.

Propylene copolymer (B)

The propylene copolymer (B) used in the invention is a copolymer of propylene and at least one olefin selected from ethylene and $\alpha$-olefin having 4 to 20 carbon atoms, having a Shore A hardness of 30 to 80, preferably 35 to70, and a melting point, as observed using a differential scanning calorimeter (DSC), of lower than 100°C, or no melting point to be observed.

The term "having no melting point to be observed" as referred to herein means that a crystal melting peak having a heat of fusion of 1 J/g or more is not observed in the range of -150 to 200°C. Conditions of the measurement are as described in the embodiment of the invention.

Further, ethylene, propylene and $\alpha$-olefins having 4 to 20 carbon atoms may be simply referred to as "$\alpha$-olefin".

For the propylene copolymer (B) used in the invention, the $\alpha$-olefin used as the comonomer is preferably ethylene and/or an $\alpha$-olefin having 4 to 10 carbon atoms. As the $\alpha$-olefin having 4 to 10 carbon atoms, particularly preferable is at least one $\alpha$-olefin selected from 1-butene, 1-hexene, and 1-octene.

The propylene copolymer (B) used in the invention comprises 45 to 92 mol%, preferably 56 to 90 mol% of the propylene units, and has a total content of ethylene and an $\alpha$-olefin having 4 to 20 carbon atoms, used as the comonomers, in the range of 8 to 55 mol%, preferably 10 to 44 mol%.

The propylene copolymer (B) used in the invention has a melt flow rate (MFR), as determined in accordance with ASTM D1238 at 230°C and a load of 2.16 kg, usually in the range of 0.01 to 1000 g/10 min, preferably 0.05 to 50 g/10 min.

A method for producing the propylene copolymer (B) is not particularly limited, but the propylene copolymer can be produced by polymerization of propylene or copolymerization of propylene and other $\alpha$-olefin(s) in the presence of a known catalyst that can polymerize an olefin stereospecifically in an isotactic structure, for example, a catalyst containing a solid titanium component and an organometallic compound as main components, or a metallocene catalyst using a metallocene compound as one component of the catalyst. Preferably, as described below, the propylene copolymer is obtained by copolymerizing propylene, ethylene and an $\alpha$-olefin having 4 to 20 carbon atoms in the presence of a metallocene catalyst.

Further, the propylene copolymer (B) used in the invention preferably has the following properties.

The propylene copolymer (B) used in the invention has a stress at 100% strain (M100), as measured in accordance with JIS K6301 using a JIS No. 3 dumbbell under the conditions of a span of 30 mm, a speed of tensile testing of 30 mm/min and a temperature of 23°C, of not more than 4 MPa, preferably not more than 3 MPa, more preferably not more than 2 Mpa. When the property is in this range, the propylene copolymer exhibits excellent flexibility, transparency and rubber elasticity.

The propylene copolymer (B) used in the invention has crystallinity, as measured by X-ray diffractometry, of not more than 20%, preferably 0 to 15%. Further, the propylene copolymer (B) has a single glass transition temperature, and it is desirable that the glass transition temperature, Tg, as measured by a differential scanning calorimeter (DSC), is usually not higher than -10°C, preferably not higher than - 15°C.

When the glass transition temperature Tg of the propylene copolymer (B) used in the invention is in the above range, the copolymer exhibits excellent low-temperature resistance and low-temperature characteristics.

In the case where a melting point (Tm, °C) is present in an endothermic curve of the propylene copolymer (B) used in the invention measured by a differential scanning calorimeter (DSC), the quantity of heat of fusion ΔH is not more than 30 J/g, and a C3 content (% by mol) of the constitutional unit derived from propylene (hereinafter, referred to as propylene content) and the quantity of heat of fusion ΔH (J/g) desirably satisfy the following relationship:

$$\Delta H < 345 \cdot Ln \ (\text{propylene content (\% by mol))} - 1492,$$

with the proviso that the propylene content satisfies the condition of $76 \leq$ propylene content (% by mol) $\leq 90$.

If the propylene copolymer (B) satisfies the above relationship between the C3 content (% by mol) and the heat of fusion AH (J/g), the compatibility with the propylene polymer (A) and the flexibility are improved, and the whitening and/or silicone cell cleavage after the heat treatment can be effectively inhibited, thus it is preferable.

The propylene copolymer (B) satisfying the relationship between the propylene content (mol%) and the heat of fusion ΔH (J/g) can be obtained by appropriately adjusting the polymerization condition to lower the crystallinity of the copolymer. For example, by appropriately selecting the catalyst, the crystallinity can be lowered, and as a result, even with the same propylene content, the heat of fusion ΔH can be lowered, whereby the propylene copolymer (B) satisfying the relationship between the propylene content (mol%) and the heat of fusion ΔH (J/g) can be prepared. As the preferable catalyst so as to lower the crystallinity, for example, a combination of a solution of a hafnium pyridyl amine catalyst in heptane, a solution of ammonium tetra(pentafluorophenyl)methyl bis(hydrogenated tallow alkyl borate) in toluene and a solution of PMAO in toluene can be used.

Further, by appropriately selecting the polymerization temperature and the polymerization pressure, the crystallinity of the propylene copolymer (B) can be adjusted. For example, the crystallinity of the obtained copolymer can be lowered by adjusting the polymerization temperature to be higher. The crystallinity of the obtained copolymer can be also lowered by adjusting the polymerization pressure to be lower. As a result, even with the same propylene content, the heat of fusion ΔH is lowered, and thus, the propylene copolymer (B) satisfying the relationship between the propylene content (mol%) and the heat of fusion ΔH(J/g) can be prepared.

The propylene copolymer (B) used in the invention desirably has a molecular weight distribution (Mw/Mn, in terms of polystyrene, Mw: weight-average molecular weight, Mn: number-average molecular weight), as measured by GPC, of not more than 4.0, preferably not more than 3.0, more preferably not more than 2.5.

The propylene copolymer (B) has triad tacticity (mm fraction), as measured by $^{13}$C-NMR, of preferably in the range of 85% or more, more preferably in the range of 85 to 97.5%, even more preferably in the range of 87 to 97%, and particularly preferably in the range of 90 to 97%. If the triad tacticity (mm fraction) is in the above-mentioned range, it is excellent particularly in balance between flexibility and mechanical strength and thus it is a suitable embodiment of the invention. The mm fraction can be measured using the method described in page 21, line 7 to page 26, line 6 of the international publication pamphlet of WO 2004-087775.

Specific examples of the propylene copolymer (B) used in the invention include the propylene/ethylene/α-olefin copolymer (B-1) as described below. By using the propylene/ethylene/α-olefin copolymer (B-1), there can be obtained a sealing sheet having good flexibility, heat resistance, mechanical strength, device sealability, and transparency. Here, the device sealability means that the ratio of the device cleaved when the device is encapsulated can be reduced due to the good flexibility.

The propylene/ethylene/α-olefin copolymer (B-1) comprises 45 to 92 mol%, preferably 56 to 90 mol%, more preferably 61 to 86 mol% of the constitutional units derived from propylene, 5 to 25 mol%, preferably 5 to 14 mol%, more preferably 8 to 14 mol% of the constitutional units derived from ethylene, and 3 to 30 mol%, preferably 5 to 30 mol%, more preferably 6 to 25 mol% of the constitutional units derived from (an) α-olefins having 4 to 20 carbon atoms. As the α-olefin, 1-butene is particularly preferable.

The propylene/ethylene/α-olefin copolymer (B-1) comprising the constitutional units derived from propylene, the constitutional units derived from ethylene, and the constitutional units derived from (an) α-olefin(s) having 4 to 10 carbon atoms in the above-described amounts, has good compatibility with the propylene polymer (A), whereby the obtained sealing sheet exhibits sufficient transparency, flexibility, heat resistance and scratch resistance.

Other components

The sealing sheet (I) used in the invention can contain components other than the thermoplastic resin composition described above within the range not adversely affecting of the purpose of the invention.

For example, in order to enhance the adhesion property, a coupling agent can be blended into the composition. There is no particular limitation on the coupling agent (Y), as long as the coupling agent can improve the adhesiveness of a layer comprising the thermoplastic resin composition and another layer comprising a polar group-containing resin or an inorganic compound such as metals in an amount of 50% by weight or more. Specifically, the coupling agents such as silane-based, titanate-based, chrome-based coupling agents, and the like are preferably used, and particularly preferably, silane-based coupling agents (silane coupling agents) are used. As the silane coupling agent, per se known silane coupling agents can be used without particular limitation, but specific examples thereof include vinyltriethoxysilane, vinyltrimethoxysilane, vinyltris(β-methoxyethoxysilane), γ-glycidoxypropyltrimethoxysilane, and γ-aminopropyltriethoxysilane. The amount of the silane coupling agent to be blended is 0.1 to 5 part(s) by weight, preferably 0.1 to 3 part(s) by weight, based on 100 parts by weight of the thermoplastic resin composition (herein, for convenience, the total amount of the components (A) and (B)).

Further, the coupling agent can be grafted with the thermoplastic resin composition using an organic peroxide. In this case, the amount of the coupling agent is preferably about 0.1 to 5 part(s) by weight, based on 100 parts by weight of the thermoplastic resin composition (herein, for convenience, the total amount of the components (A) and (B)). Also, by using the silane grafted thermoplastic resin composition, adhesiveness to glass or plastic similar to that of the silane coupling agent blend can be obtained.

The sealing sheet (I) constituting a part of the invention may be partially crosslinked, but preferably uncrosslinked. Here, "uncrosslinked" means that the content of the boiling xylene insoluble portion in the total organic matters contained in the sheet is 0.1% by weight or less.

Although well known organic peroxides can be used without particular limitation as the organic peroxide, specific examples thereof include dilauroyl peroxide, 1,1,3,3-tetra methylbutylperoxy-2-ethylhexanoate, dibenzoylperoxide, t-amylperoxy-2-ethylhexanoate, t-butylperoxy-2-ethylhexanoate, t-butylperoxyisobutylate, t-butylperoxymaleic acid, 1,1-di(t-amylperoxy)-3,3,5-trimethylcyclohexane, 1,1-di(t-amylperoxy)cyclohexane, t-amylperoxyisononanoate, t-amylperoxy n-octoate, 1,1-di(t-butylperoxy)-3,3,5-trimethylcyclohexane, 1,1-di(t-butylperoxy)cyclohexane, t-butylperoxyisopropyl carbonate, t-butylperoxy-2-ethylhexyl carbonate, 2,5-dimethyl-2,5-di(benzoylperoxy)hexane, t-amylperoxybenzoate, t-butylperoxy acetate, t-butylperoxy isononanoate, t-butylperoxybenzoate, 2,2-di(butylperoxy) butane, n-butyl-4,4-di(t-butylperoxy)butylate, methylethylketoneperoxide, ethyl 3,3-di(t-butylperoxy)butylate, dicumylperoxide, t-butylcumylperoxide, di-t-butylperoxide, 1,1,3,3-tetramethylbutylhydroperoxide, and acetylacetoneperoxide and the like.

Further, the sealing sheet (I) constituting a part of the composite sheet of the invention can comprise other various additives. Examples of the additives include an ultraviolet absorber for prevention of deterioration caused by the ultraviolet ray of the solar rays, a light stabilizer, and an antioxidant.

As the ultraviolet absorber, specifically a benzophenone-based ultraviolet absorber such as 2-hydroxy-4-methoxybenzophenone, 2-2-dihydroxy-4-methoxybenzophenone, 2-hydroxy-4-methoxy-4-carboxybenzophenone or 2-hydroxy-4-N-octoxybenzophenone, a benzotriazole-based ultraviolet absorber such as 2-(2-hydroxy-3,5-di-t-butylphenyl)benzotriazole or 2-(2-hydroxy-5-methylphenyl)benzotriazole, salicylic acid ester such as phenylsalicylate or p-octylphenyl salicylate can be used.

As the light stabilizer, a hindered amine-based light stabilizer is used. Further, as the antioxidant, a hindered phenol-based or phosphate-based antioxidant is used.

Furthermore, various additives other than the above-described additives, various resins and/or rubbers other than the component (A) or (B) and one or two or more kinds of the additives selected from, plasticizers, fillers, colorants, dyes, antistatic agents, antibacterial agents, antifungal agents, flame retardants, dispersing agents, and the like can be contained as needed. Further, various additives as disclosed in, for example, JP-A No. 2003-092421 can be added.

Constitution and molding processes for sealing sheet (I)

The sealing sheet (I) constituting a part of the composite sheet of the invention has a thickness of usually 0.1 mm to 5 mm, preferably 0.1 to 1 mm. If the thickness is within the above range, damage of various members, solar cell devices or the like can be inhibited in the lamination process, and in the case where it is used in a solar cell module, a sufficient light beam transmission can be achieved, leading to high photovoltaic generation, thus it is preferable.

The molding method for the sealing sheet (I) is not particularly limited, but a known extrusion molding (such as cast molding, extrusion sheet molding, inflation molding and injection molding), press molding, calendar molding and the like can be employed. Further, the sheet can be embossing processed, thereby modifying the surface of the sheet to prohibit blocking between the sheets, and further making the emboss function as a cushion to prevent the damage for various devices such as a solar cell device upon lamination, thus it is preferable.

The sealing sheet (I) constituting the composite sheet of the invention desirably has an internal haze in the range of 0.1% to 15%, preferably 0.1% to 10%, as measured with a sample having a thickness of 0.5 mm or less.

The sealing sheet (I) constituting the composite sheet of the invention preferably has a light transmittance of 86% or more, preferably of 88% or more, measured in the sheet (after the release film was removed) after press-molding to 0.5 mm or less obtained by melting under heating to 160°C or higher with protection with a release film having a flat surface, such as PET, to remove the effect of the irregularities of the film surface, followed by cooling. Thus obtained sheet under these conditions that satisfies the above-described light transmittance can be used with little deterioration in the power generation efficiency, whereby it can be preferably used for the invention.

The base sheet (II)

At least a part of the base sheet (II) used in the composite sheet of the invention is composed of a polypropylene resin. The polypropylene resin can provide the base sheet (II), and the composite sheet, which are excellent in heat resistance, transparency, toughness and economical efficiency, and are highly valuable in practical use.

Further, the base sheet (II) is excellent in barrier property for moisture, whereby it is advantageous in achieving the purpose of the invention.

Moreover, the base sheet (II) often has a refractive index similar to that of the sealing sheet (I), and thus easy inhibition of optical loss by the reflection and the scattering on the laminated interface can be cited as one of the advantages of the base sheet (II) comprising the polypropylene resin.

Polypropylene resin

The polypropylene resin constituting at least a part of the base sheet, which is preferably used in the invention, may be a propylene homopolymer or a copolymer of propylene and a small amount of other $\alpha$-olefin. Examples of the $\alpha$-olefin can be used in the copolymer include ethylene, 1-butene, 1-pentene, 1-hexene, 1-octene, 1-decene, 1-dodecene, and 4-methyl-1-pentene. Two kinds of these $\alpha$-olefins or more may be copolymerized. In the case of the copolymer, the propylene content is preferably 95 mol% or more, particularly preferably 97 mol% or more. Further, the density is preferably 900 g/cm$^3$ or more, preferably 905 to 950 g/cm$^3$.

The polypropylene resin preferably has a melt flow rate, as measured at 230°C and a load of 2.16 kg, in the range of 0.1 to 50 g/10 min, and preferably has a softening point of 80 to 125°C (JIS K7191: 4.6 kg/cm$^2$).

The polypropylene resin may be any of an isotactic polypropylene, a syndiotactic polypropylene and an atactic polypropylene, and among these, particularly preferred is an isotactic polypropylene. In this case, the isotactic pentad fraction is preferably 90 or higher.

In addition, in the case of the copolymer, it may be any of a random copolymer and a block copolymer.

Other components

The base sheet (II) constituting a part of the invention may contain other components, in addition to the above polypropylene resin, within the range not adversely affecting the purpose of the invention.

For example, the base sheet (II) may contain various resins other than the above-mentioned polypropylene resin, and fillers. Further, for example, various additives that can be added to the sealing sheet (I) (various coupling agents, typically exemplified by silane coupling agent, organic oxide and/or a weathering stabilizer) can be added as needed, and further a plasticizer, a pigment, a dye, an antistatic agent, an antibacterial agent, an antifungal agent, a flame retardant and/or a dispersing agent, or the like, can be also added.

Constitution and molding processes for sealing sheet (II)

The base sheet (II) usually has a thickness of 20 $\mu$m to 500 $\mu$m, preferably, 20 $\mu$m to 200 $\mu$m. If the thickness is within the above range, damage of glass, solar cell devices or the like in the lamination process can be inhibited, and a sufficient light transmission can be achieved, leading to high photovoltaic power generation, thus it is preferable.

The base sheet (II) can be prepared by a conventional method including a T-die cast film method. The base sheet (II) may be prepared as a monolayer film or as a co-extrusion film with two or more kinds of the above materials or other resins (including the resin used for sealing film (I)) by a co-extrusion method. There can be exemplified a double layer constitution, wherein a layer, the main component of which is a polypropylene resin having a lower melting point, is provided on the side to be adhered in order to form a thermal fusion with the sealing film (I) at a low temperature.

A base sheet (II) may be an unstretched film, but a stretched film obtained by performing uniaxial stretching or biaxial stretching is preferable. Specifically, from the viewpoint of improving the toughness, the transparency, the heat resistance, the gas barrier property and the moisture barrier property in film, a biaxially stretched film is preferably used.

Metal or inorganic compound layer

It is preferable that either side or both sides of the surfaces of the base sheet (II) is/are covered with a metal or an inorganic compound layer. The existence of the metal or the inorganic compound layer improves the various barrier properties such as moisture barrier property. So, the composite film using such a base film (I) is highly valuable in practice.

As the materials used in the metal or inorganic compound layer, a metal such as Al or metal oxide, metal nitride, metal nitride oxide or the like using at least one kind of metal such as Si, Al, In, Sn, Zn, Ti, Cu, Ce, Ge, Ta, Zr and V can be used, and more specifically, a metal oxide such as silicon oxide, aluminum oxide, magnesium oxide and ITO can preferably be used. From the viewpoint of the cost, the transparency, or the like, silicon oxide is specifically preferable.

If the metal or inorganic compound layer is too thick, there is a risk of generation of a crack caused by the bending stress. And if the metal or inorganic compound layer is too thin, the layer is distributed in island shape. In each case, the barrier property is deteriorated. Thus, the thickness of an inorganic compound layer is preferably 5 nm to 1000 nm, but is not limited thereto.

As a film-forming method for the metal or inorganic compound layer, sputtering, CVD method, MBE method or other deposition method can be suitably used. The CVD method is preferable for its simplicity and convenience. An atmospheric pressure CVD method, a plasma CVD method or the like is preferable from the viewpoint that the composition and the physical properties can be controlled precisely, but not limited thereto.

Further, the metal or inorganic compound layer may be a monolayer and may have a laminated structure with multiple layers comprising different kinds of inorganic compounds as the main components. The monolayer is preferable from the viewpoint of the cost and the simplicity and convenience, and the multiple structures are preferable from the viewpoint of the reliability as a barrier.

Constitution of composite sheet

As described above, it is sufficient that the composite sheet of the invention has at least one layer of the sealing sheet (I) of the invention and at least one layer of the base sheet (II) comprising a polypropylene resin. Accordingly, the sealing sheet (I) may be of one layer or two or more layers. One layer is preferable from the viewpoint of saving costs simplifying the structure, and of effective use of the light by reducing an interfacial reflection between the layers upon sealing a device that utilize light.

Also the base sheet (II) may be of one layer or two or more layers. One layer is preferable from the viewpoint of saving costs by simplifying the structure, and of effective use of the light by reducing an interfacial reflection between the layers upon sealing a device that utilizes light.

The composite sheet of the invention may comprise layers other than the sealing sheet (I) and the base sheet (II) (hereinafter, also referred to as the other layers) or may consist only of the sealing sheet (I) and the base sheet (II), namely without the other layers.

The other layers can include a hard coating layer to protect the front side or the back side, an adhesive layer, an antireflection layer, a gas barrier layer and an antifouling layer, according to the classification based on their purposes. The other layers can include a layer comprising an ultraviolet curable resin, a layer comprising a thermosetting resin, a layer comprising a polyolefin resin, a layer comprising a carboxylic acid modified polyolefin resin, and a layer comprising a fluorine containing resin or the like, according to the classification based on their materials.

The positional relation between the sealing sheet (I), the base sheet (II) and the other layers is not particularly limited, and preferable layer structure is selected according to the purpose of the invention. That is, the other layer(s) may be positioned between the sealing sheet (I) and the base sheet (II), or positioned on the outmost layer of the composite sheet. Alternatively, they may be positioned on other places. The number of the other layers is not particularly limited, and any number of the other layers can be formed, or alternatively, other layers are not necessarily formed.

It is particularly preferable that only one layer of the sealing sheet (I) and one layer of the base sheet (II) are formed to be attached each other directly without forming the other layers, from the viewpoint of saving costs by simplifying the structure, and of effective use of the light by reducing an interfacial reflection between the layers as possible upon sealing a device using light.

The composite sheet is formed by laminating multiple layers. The method for the lamination in the process is not particularly limited, but there can be exemplified a laminating method by co-extrusion, a method of extrusion lamination of thermoplastic resin compound to form the melted sealing sheet (I) on the base sheet (II) and a method of heat-laminating the sealing sheet (I) and the base sheet (II). Further, the lamination can be carried out by a dry laminating method or a heat laminating method with an appropriate adhesive (for example, a maleic acid anhydride-modified polyolefin resin (for example, ADMER manufactured by Mitsui Chemicals, Inc., MODIC manufactured by Mitsubishi Chemical Co., etc.), a low (non) crystalline flexible polymer such as unsaturated polyolefin, an acrylic adhesive including terpolymers of ethylene/acrylic acid ester/maleic acid anhydride (for example, BONDINE manufactured by Sumitomo chemical Co., Ltd.), a copolymer of ethylene/vinyl acetate or an adhesive resin compound containing the same, etc).

An adhesive having heat resistance at around 120°C to 150°C is preferably used, and a polyester or a polyurethane adhesive is preferably exemplified. Further, in order to improve the adhesiveness between the layers, silane coupling treatment, titanium coupling treatment, corona treatment plasma treatment, and so on may be employed.

Use of the composite sheet

Since the composite sheet is excellent in the heat resistance, the transparency and the flexibility, and further excellent in the moisture barrier property and costs, it can be preferably employed in an electric or electronic device that are vulnerable to moisture and an electric or electronic device that utilizes strong light, and in particular, it is preferably used as a composite sheet for sealing and protecting a solar cell. As the composite sheet for sealing and protecting a solar cell, the composite sheet of the invention may be used both as it is and after being treated with a process such as addition of other layers.

The solar cell module

A solar cell module typically has a structure such that the solar cell device formed of polycrystalline silicon is laminated between sealing sheets for a solar cell, and further covered with protective sheets on the front and the back sides. That is, a typical solar cell module has the following structure: (1) a protective sheet for a solar cell module (a surface protective sheet)/(2) a sealing sheet for a solar cell/(3) a solar cell device/(4) a sealing sheet for the solar cell / (5) a protective sheet for the solar cell module (a sheet for protecting the back side).

The composite sheet can be preferably used as a composite sheet corresponds to those comprising (1) a protective sheet for a solar cell module (surface protective sheet) and (2) a sealing sheet for the solar cell, and/or, those comprising (4) a sealing sheet for the solar cell and (5) a protective sheet for the solar cell module (a sheet for protecting back side). Specifically, it can be preferably used as the composite sheet corresponds to those comprising (4) the sealing sheet for solar cell and (5) the protective sheet for solar cell module (a sheet for protecting back side).

However, the solar cell module, which is a preferable embodiment of the invention, is not limited to the above-described constitution, and may be provided with layers other than the above layers as needed, as for as the purpose of the invention is not adversely affected. Typically, the solar cell module may be provided with an adhesive layer, an impact absorption layer, a coating layer, an antireflection layer, a back-side reflecting layer, light diffusion layer and the like, but not limited thereto. The positions of laminating the layers are not particularly limited, and the layers can be formed on appropriate positions, considering the purpose of forming the layers.

The solar cell device

The solar cell device in the solar cell module, which is a preferable embodiment of the invention, is not particularly limited as long as it is capable of generating electric power using a photovoltaic effect of a semiconductor, and examples thereof include a silicon (monocrystalline, polycrystalline or non-crystalline (amorphous)) solar cell, a compound semiconductor (Group III-V, Group II-VI, or other Groups) solar cell, a wet solar cell and an organic semiconductor solar cell can be used. Among these, a polycrystalline silicon solar cell is preferable, from the viewpoint of the balance between the performance of electric power generation and the cost.

Although both silicon and compound semiconductor have excellent properties for the solar cell device; however, it is known that they are likely to be damaged by an external stress, impact or the like. Since the composite sheet of the invention has a sealing sheet (I) comprising a specific thermoplastic resin composition with excellent flexibility, it absorbs the stress, the impact or the like to the solar cell device to exhibit a significant effect of inhibiting the damage of the solar cell device. Here, it is preferable that the sealing sheet (I) is directly attached to the solar cell device.

Since the sealing sheet (I) comprises a specific thermoplastic resin, even after a solar cell module was prepared using the composite sheet, a solar cell device can be relatively easily taken out, which is preferable from the viewpoint of recycling.

The power generating facility

The solar cell module, as a preferable embodiment of the invention, is excellent in productivity, power generation efficiency, service life or the like. For this reason, the power generating installation obtained by using the solar cell module is excellent in cost, power generation efficiency, service life or the like, and is highly valuable in practical use.

The power generating facility described above is preferably used for the long-term uses, no matter whether it is outdoor use or indoor use, including uses on building roofing, uses as a portable electric source for outdoor activities such as camping, an auxiliary power source for a vehicle battery and the like.

EXAMPLES

The present invention is further described with reference to the following Examples and Comparative Examples, but it should not be construed that the invention is limited thereto.

(Methods for measurement)

In the following Examples and Comparative Examples, the characteristics of the composite sheets were measured in the following manners.

- Heat resistance (TMA)

A pressure of 2 kg/cm$^2$ was applied to the sealing sheet with a flat surface indenter having a diameter of 1.8 m$\phi$ at a heating rate of 5°C/min in accordance with JIS K7196 to obtain a TMA curve. From the TMA curve, a needle penetration temperature (°C) was determined.

- Permanent compression set (CS)

The permanent compression set of the sealing sheet was measured in accordance with JIS K 6301 in the following manner. That is, 6 press sheets each having a thickness of 2 mm were stacked and compressed by 25%, maintained at a predetermined temperature (23°C or 70°C) for 24 hours, and then released. Thereafter, the thickness after the test was measured. From the result, a residual set (permanent compression set) after maintenance for 24 hours was determined according to the following equation.

$$\text{Residual set} = 100 \times (\text{Thickness before test} - \text{Thickness after test}) \, / \, (\text{Thickness before test} - \text{Thickness upon compression})$$

- Transparency (Internal haze)

The quantities of the diffuse transmitted light and of the total transmitted light of the sheet were measured in a cyclohexanol solution using a digital turbidity meter "NDH-2000" manufactured by Nippon Denshoku Industries Co., Ltd., and the internal haze was calculated according to the following equation.

$$\text{Internal haze (\%)} = 100 \times (\text{Quantity of the diffuse transmitted light}) \, / \, (\text{Quantity of the total transmitted light})$$

- Transparency (Light transmittance)

The light transmittance was measured using a digital turbidity meter "NDH-2000" manufactured by Nippon Denshoku Industries Co., Ltd, according to the following equation on a sample (thickness: 0.4 mm) obtained by pressurizing and heating an original film being protected with a PET film (Lumira, manufactured by Toray Co., Ltd.) having a flat surface at 160°C (160°C, 2 atm, 10 min), cooling with air, and then peeling the PET film off to remove the effect of the irregularities of the film surface.

$$\text{Light transmittance (\%)} = 100 \times (\text{Quantity of the total transmitted light}) \, / \, (\text{Quantity of the incident light})$$

- Adhesiveness with a base film

The sealing sheet and a base film (BOPP, or a PET film) were adhered to each other at 150°C and under a pressure of 2 atm for 10 min. The bonds were classified in the following criteria.

AA: Well adhered (Unpeelable)
BB: Slightly adhered (Peelable)
CC: Not adhered

- Plasticization by reheating

The sealing sheet was heated to 190°C, and it was observed whether plasticization and fluidization occurs or not.

(Raw materials)

The kinds, physical properties or the like of the resins used in preparation of the samples for the following Examples and Comparative Examples are as follows.

(A)

Isotactic polypropylene (rPP):

propylene/ethylene/1-butene random copolymer having the following properties was used.
Tm = 140°C,
Melt Flow rate (MFR) (230°C) = 7 g/10 min,
Isotactic pentad fraction (mmmm) = 0.96,
Molecular weight distribution (Mw/Mn) = 4.8,
Constitutional units derived from ethylene (hereinafter, referred to as ethylene content) = 2.0 mol%, and
Constitutional units derived from 1-butene (hereinafter, referred to as 1-butene content) = 1.5 mol%

(B) Propylene/ethylene/1-butene copolymer (PEBR)

A copolymer prepared in the following manner was used:
To a 2000 mL polymerization vessel sufficiently purged with nitrogen, 917 mL of dry hexane, 90 g of 1-butene and triisobutyl aluminum (1.0 mmol) were charged at normal temperature, and then the internal temperature of the polymerization vessel was elevated to 65°C and the polymerization vessel was pressurized with propylene such that the pressure in the system reached 0.77 MPa, and thereafter the pressure in the system was adjusted to 0.79 MPa with ethylene. Subsequently, a solution formed by contacting 0.002 mmol of dimethylmethylene(3-tert-butyl-5-methylcyclopentedienyl)(fluorenyl)zirconium dichloride with 0.6 mmol of methylaluminoxane in terms of aluminum (manufactured by Tosoh Finechem Corporation) in toluene was added to the polymerization vessel. Polymerization was conducted for 20 minutes while maintaining the temperature in the system at 65°C and the pressure in the system at 0.78 MPa with ethylene. 20 mL of methanol was added thereto, thereby terminating the polymerization. After releasing the pressure, a polymer was precipitated from a polymerization solution in 2 L of methanol and dried at 130°C for 12 hours under vacuum. The resulting polymer was 60.4 g, and had an MFR (230°C) of 7.0 g/10 min, a glass transition temperature Tg of -27°C, an ethylene content of 14 mol%, a 1-butene content of 20 mol%, a molecular weight distribution (Mw/Mn), as measured by GPC, of 2.0, a mm value of 92%, and a Shore A hardness of 42. Further, the heat of fusion by DSC measurement was less than 0.5 (J/g), and any clear melting point was not observed.

(C) Propylene-1-butene copolymer (PBR)

An amorphous propylene-1-butene copolymer manufactured by Sumitomo Chemical Co., Ltd.; (trade name: Tafcelen T3512), and having

a melting point (Tm) = 158°C, and
a Shore A hardness = 63

was used.

(D) Ethylene-vinyl acetate copolymer (EVA)

An ethylene/vinyl acetate copolymer having constitutional units derived from vinyl acetate (hereinafter, referred to as a vinyl acetate content) = 28 wt% and

   a melt flow rate (MFR) (190°C) = 15 g/10 min,

was used.

(X) Silane coupling agent

3-Methacryloxypropyltrimethoxysilane manufactured by Dow Corning Toray Co., Ltd. was used.

(Y) Peroxide

DCP (dicumyl peroxide) manufactured by Arkema Yoshitomi, Ltd. was used.

(P) BOPP film

A biaxially stretched polypropylene film having a thickness of 50 $\mu$m manufactured by Tohcello Co., Ltd. (HC-OP, one-side heat-sealable type) was used.

(Q) PET film

A biaxially stretched polyethylene terephthalate film (trade name: Lumira S10, thickness: 50$\mu$) manufactured by Toray Co., Ltd. was used.

[Example 1]

The thermoplastic composition comprising 20 by weight of (A) isotactic polypropylene (rPP), 80 by weight of (B) propylene·ethylene/1-butene copolymer (PEBR), 0.5 (PHR) of (X) silane coupling agent, and 0.06 (PHR) of (Y) peroxide (kneaded for 5 minutes at 190°C using a Labo plastomill, manufactured by Toyo Seiki Seisaku-Sho, Ltd.) was molded into a press sheet having a thickness of 2 mm at 190°C. Using the sheet, the heat resistance (TMA) ,the permanent compression set (23°C and 70°C) and further occurrence of plasticization by reheating were evaluated.
Further, a press sheet having a thickness of 400 $\mu$m was prepared at 190°C using the composition obtained in the same manner, and then the adhesiveness of the press sheet with the (P) BOPP film was evaluated. The results are shown in Table 1.

[Comparative Example 1]

In the similar manner to Example 1, except that (C) propylene·1-butene copolymer (PBR) was used instead of (B) propylene·ethylene·1-butene copolymer (PEBR), a sample was prepared and evaluated. The results are shown in Table 1.

[Comparative Example 2]

A thermoplastic resin composition comprising 100 parts by weight of (D) ethylene-vinyl acetate copolymer (EVA), 1.5 parts by weight of (X) silane coupling agent, and 1.0 part by weight of (Y) peroxide was obtained (by kneading at 120°C for 5 minutes using a Labo plastomill manufactured by Toyo Seiki Seisaku-Sho, Ltd.). The composition was press-molded at 140°C to prepare (uncrosslinked) press sheets having thicknesses of 2 mm and 400 $\mu$m.
The press sheet having a thickness of 2 mm was subjected to heat treatment at 140°C under a pressure of 2 atm for 10 min (the same conditions as the test of adhesion with a base material), and then the heat resistance (TMA) and the permanent compression set (23°C and 70°C) of the treated sheet were measured, and it was observed whether plasticization by reheating occurs or not.
Further, the adhesiveness of the press sheet having a thickness of 400 $\mu$m with (P) BOPP film was evaluated. The results are shown in Table 1.

[Comparative Example 3]

In the similar manner to Example 1, except that a (Q) PET film was used instead of the (P) BOPP film, the adhesiveness of the sample was evaluated. The results are shown in Table 1.

[Table 1]

| | | Example 1 | Comparative Example 1 | Comparative Example 2 | Comparative Example 3 |
|---|---|---|---|---|---|
| TMA | °C | 118 | 122 | 130°C< | 119 |
| CS (23°C) | % | 20 | 68 | 5> | 22 |
| CS (70°C) | % | 61 | 81 | 5> | 62 |
| Internal haze | % | 1.5 | 2.3 | 1.4 | 1.7 |
| Light transmittance | % | 92 | 84 | 94 | 92 |
| Adhesiveness with base sheet | | AA | AA | BB | CC |
| Occurrence of plasticization by reheating | | Possible | Possible | Impossible | Possible |

**Claims**

1. A composite sheet comprising:

   a sealing sheet (I) one of whose layers comprises a thermoplastic resin composition comprising:

   (i) 0 to 90 parts by weight of a propylene polymer (A) having a melting point, as measured by a differential scanning calorimeter, of 100°C or higher, and
   (ii) 10 to 100 parts by weight of a propylene copolymer (B) formed from propylene and at least one olefin selected from the group consisting of ethylene and α-olefins having 4 to 10 carbon atoms, the copolymer having a shore A hardness of 30 to 80, a melting point, as measured by a differential scanning calorimeter, of lower than 100°C, or has no melting point to be observed (with the total of (A) and (B) being 100 parts by weight),

   wherein the thermoplastic resin composition has a permanent compression set measured at 23°C, of 5 to 35%, and a permanent compression set measured at 70°C of 50 to 70%, the permanent compression set of the thermoplastic resin being measured by stacking six press sheets of the resin each having a thickness of 2 mm, compressing the stack by 25%, maintaining the compressed stack at the measurement temperature (23°C or 70°C) for 24 hours and releasing the stack from compression, the permanent compression set being determined in accordance with JIS K 6301 by the equation:

   $$\text{Permanent compression set} = \{(\text{Thickness before test}) - (\text{Thickness after test})\}/\{(\text{Thickness before test}) - (\text{Thickness upon compression})\}; \text{ and}$$

   a base sheet (II) one of whose layers comprises a polypropylene resin.

2. A composite sheet according to Claim 1, wherein the propylene copolymer (B) comprises 45 to 92 mol% of constitutional units derived from propylene, 5 to 25 mol% of constitutional units derived from ethylene and 3 to 30 mol% of constitutional units (a) derived from (an) α-olefin(s) having 4 to 20 carbon atoms.

3. A composite sheet according to Claim 1 or Claim 2, wherein the base sheet (II) is biaxially stretched.

4. A composite sheet according to any preceding Claim, wherein the base sheet (II) has a metal or inorganic compound layer on its surface.

5. A composite sheet according to any preceding Claim, wherein the sealing sheet (I) and the base sheet (II) are directly laminated.

6. Use of a composite sheet according to any preceding Claim for sealing a solar cell.

7. A solar cell module prepared by using the composite sheet according to any of Claims 1 to 5.

8. A power generating facility including a solar cell module as defined in Claim 7.


**Patentansprüche**

1. Verbundfolie, umfassend:

   eine Abdichtungslage (I), in der eine ihrer Schichten eine thermoplastische Harzzusammensetzung umfasst, umfassend:

   (i) 0 bis 90 Gew-Teile eines Propylenpolymers (A) mit einem Schmelzpunkt, gemessen mit einem Differential-Rasterkalorimeter, von 100°C oder höher und
   (ii) 10 bis 100 Gew.-Teile eines Propylencopolymers (B), das aus Propylen und mindestens einem Olefin ausgewählt aus der Gruppe bestehend aus Ethylen und $\alpha$-Olefinen mit 4 bis 10 Kohlenstoffatomen gebildet ist, wobei das Copolymer eine Shore A-Härte von 30 bis 80 hat, einen Schmelzpunkt, gemessen durch ein Differential-Rasterkalorimeter, von weniger als 100°C hat oder kein Schmelzpunkt beobachtet wird (wobei die Gesamtheit von (A) und (B) 100 Gew.-Teile sind),

   worin die thermoplastische Harzzusammensetzung einen bei 23°C gemessenen dauerhaften Druckverformungsrest von 5 bis 35 % hat, und einen bei 70°C gemessenen dauerhaften Druckverformungsrest von 50 bis 70 % hat, wobei der dauerhafte Druckverformungsrest des thermoplastischen Harzes gemessen wird, indem sechs Presslagen des Harzes, die jeweils eine Dicke von 2 mm haben, gestapelt werden, der Stapel um 25 % komprimiert wird, der komprimierte Stapel bei der Messtemperatur (23°C oder 70°C) über 24 Stunden gehalten wird und der Stapel aus der Kompression freigesetzt wird, wobei der dauerhafte Druckverformungsrest gemäß JIS K 6301 durch die folgende Gleichung bestimmt wird:

   ```
   Dauerhafter Druckverformungsrest
   = {(Dicke vor dem Test) - (Dicke nach dem Test)}/
   {(Dicke vor dem Test) - (Dicke bei Kompression)};
   ```

   und
   eine Basislage (II), in der eine ihrer Schichten ein Polypropylenharz umfasst.

2. Verbundfolie gemäß Anspruch 1, worin das Propylencopolymer (B) 45 bis 92 Mol% an Aufbaueinheiten abgeleitet von Propylen, 5 bis 25 Mol% an Aufbaueinheiten abgeleitet von Ethylen und 3 bis 30 Mol% an Aufbaueinheiten (a) abgeleitet von (einem) $\alpha$-Olefin(en) mit 4 bis 20 Kohlenstoffatomen umfasst.

3. Verbundfolie gemäß Anspruch 1 oder Anspruch 2, worin die Basislage (II) biaxial gestreckt ist.

4. Verbundfolie gemäß irgendeinem der vorhergehenden Ansprüche, worin die Basislage (II) eine Schicht eines Metalls oder einer anorganischen Verbindung auf ihrer Oberfläche aufweist.

5. Verbundfolie gemäß irgendeinem der vorhergehenden Ansprüche, worin die Abdichtungslage (I) und die Basislage (II) direkt laminiert sind.

**6.** Verwendung der Verbundfolie gemäß irgendeinem vorhergehenden Anspruch zum Versiegeln einer Solarzelle.

**7.** Solarzellenmodul, das unter Verwendung der Verbundfolie gemäß irgendeinem der Ansprüche 1 bis 5 hergestellt wird.

**8.** Energieerzeugungseinrichtung, die ein Solarzellenmodul, wie in Anspruch 7 definiert, einschließt.

**Revendications**

**1.** Feuille composite comprenant :

une feuille d'étanchéité (I) dont l'une de ses couches comprend une composition de résine thermoplastique comprenant :

(i) de 0 à 90 parties en poids d'un polymère de propylène (A) ayant un point de fusion, tel que mesuré par un calorimètre différentiel à balayage, de 100°C ou plus, et
(ii) de 10 à 100 parties en poids d'un copolymère de propylène (B) formé de propylène et d'au moins une oléfine choisie dans le groupe constitué d'éthylène et d'$\alpha$-oléfines ayant 4 à 10 atomes de carbone, le copolymère ayant une dureté Shore A de 30 à 80, un point de fusion, tel que mesuré par un calorimètre différentiel à balayage, inférieur à 100°C, ou n'a pas de point de fusion à observer (avec le total de (A) et (B) étant de 100 parties en poids),

où la composition de résine thermoplastique présente une déformation permanente par compression mesurée à 23°C de 5 à 35%, et une déformation permanente par compression mesurée à 70°C de 50 à 70%, la déformation permanente par compression de la résine thermoplastique étant mesurée par l'empilement de six feuilles pressées de la résine ayant chacune une épaisseur de 2 mm, la compression de la pile de 25%, le maintien de la pile comprimée à la température de mesure (23°C ou 70°C) pendant 24 heures et l'arrêt de la compression de la pile, la déformation permanente par compression étant déterminée conformément à JIS K 6301 par l'équation :

$$\text{déformation permanente par compression} = \{(\text{Épaisseur avant essai}) - (\text{Épaisseur après essai})\} / \{(\text{Épaisseur avant essai}) - (\text{Épaisseur lors de la compression})\} \; ; \text{ et}$$

une feuille de base (II) dont l'une de ses couches comprend une résine de polypropylène.

**2.** Feuille composite selon la revendication 1, où le copolymère de propylène (B) comprend de 45 à 92 % en moles de motifs constitutionnels dérivés du propylène, de 5 à 25 % en moles de motifs constitutionnels dérivés de l'éthylène et de 3 à 30 % en moles de motifs constitutionnels (a) dérivés d'une $\alpha$-oléfine/d'$\alpha$-oléfines ayant 4 à 20 atomes de carbone.

**3.** Feuille composite selon la revendication 1 ou 2, où la feuille de base (II) est étirée biaxialement.

**4.** Feuille composite selon l'une des revendications précédentes, où la feuille de base (II) a une couche de métal ou de composé inorganique sur sa surface.

**5.** Feuille composite selon l'une des revendications précédentes, où la feuille d'étanchéité (I) et la feuille de base (II) sont directement stratifiées.

**6.** Utilisation d'une feuille composite selon l'une des revendications précédentes pour assurer l'étanchéité d'une cellule solaire.

**7.** Module de cellule solaire préparé en utilisant la feuille composite selon l'une des revendications 1 à 5.

8. Installation de production d'énergie comportant un module de cellule solaire tel que défini dans la revendication 7.

[Fig.1]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002134768 A
- JP 2003092421 A

- WO 2004087775 A